# EUROPÄISCHE PATENTSCHRIFT

(11) **EP 2 236 641 B1**
(45) Veröffentlichungstag und Bekanntmachung des Hinweises auf die Patenterteilung: **05.10.2011**
(21) Anmeldenummer: 09004581.6
(22) Anmeldetag: 30.03.2009
(51) Int. Cl.: C23C 14/02, C23C 14/32

(54) **Verfahren zur Vorbehandlung von Substraten fuer PVD Verfahren**
Method for pre-treating substrates for PVD procedures
Procédé de traitement préalable de substrats pour le procédé de PVD

(43) Veröffentlichungstag der Anmeldung: 06.10.2010
(73) Patentinhaber: Oerlikon Trading AG, Trübbach, 9477 Trübbach (CH)
(72) Erfinder: Rudigier, Helmut, 7310 Bad Ragaz (CH); Ramm, Juergen, Dr., 7304 Maienfeld (CH); Widrig, Beno, 7310 Bad Ragaz (CH); Vom Braucke, Troy, 9470 Buchs (CH)
(74) Vertreter: Misselhorn, Hein-Martin

(56) Entgegenhaltungen:
- WO-A-2006/099760
- DE-C1- 4 238 784
- DE-C2- 3 390 523

## Beschreibung

Die Erfindung bezieht sich auf ein Verfahren zur Vorbehandlung von Substraten, wie sie üblicherweise vor der Beschichtung von Substraten mittels PVD durchgeführt werden kann.

Die kathodische Funkenverdampfung ist ein seit Jahren etabliertes Verfahren, das für die Beschichtung von Werkzeugen und Bauteilen Anwendung findet und mit dem sowohl metallische Schichten in breiter Vielfalt als auch Metallnitride, Metallkarbide und Metallkarbonitride abgeschieden werden. Bei diesem Verfahren sind die Targets Kathode einer Funkenentladung, die bei niedrigen Spannungen und hohen Strömen betrieben und mit der das Target(Kathoden)material verdampft wird. Als einfachste und billigste Stromversorgungen zum Betreiben der Funkenentladungen werden meist Gleichspännungsstromversorgungen benutzt.

Aus der DE 42 38 784 C1 ist ein Verfahren zur Verringerung der Korrosionsanfälligkeit und Erhöhung der Verschleißbeständigkeit von Gegenständen aus niedrig legierten, korrosionsanfälligen Stählen. Um die Verringerung der Korrosionsanfälligkeit und die Erhöhung der Verschleißbeständigkeit der Gegenstände aus niedrig legierten und damit korrosionsanfälligen Stählen in einem einzigen Prozess zu erreichen, werden zuerst die Oberfläche der Gegenstände durch ein im Vakuum stattfindendes Ionen-Bombardement gereinigt, anschließend im Vakuum in die gereinigte Oberfläche durch ein Chromionen-Bombardement Chromatome eindiffundiert und schließlich auf die entstandene ionengestützt abgeschiedene Diffusionsschicht ohne Prozessunterbrechung eine Auftragsschicht in Form einer Hartstoffschicht im Vakuum abgeschieden.

Es ist bekannt, dass das durch die kathodische Funkenentladung verdampfte Material einen hohen Anteil an Ionen enthält. Aus Johnson, "P.C. in Physics of Thin Films", vol. 14, Academic Press, 1989, pp 129-199 sind dafür Werte zwischen 30% und 100% je nach Kathodenmaterial und Grösse des Funkenstromes bekannt. Dieser hohe Anteil an ionisiertem Dampf ist wünschenswert bei der Schichtsynthese.

Besonders vorteilhaft wirkt sich der hohe Ionisierungsgrad aus, wenn er bei der Schichtsynthese mit einem negativen Bias am Substrat gekoppelt wird und dadurch die Beschleunigung und die Energie der Ionen zum Substrat hin erhöht und variiert werden kann. Die auf diese Weise synthetisierten Schichten weisen eine höhere Dichte auf und es lassen sich über die Veränderung der Biasspannung einige Schichteigenschaften wie beispielsweise der Stress der Schicht und die Schichtmorphologie beeinflussen.

Die Funkenverdampfung ist allerdings auch dafür bekannt, dass das verdampfte Material in Abhängigkeit von dessen Schmelzpunkt mehr oder weniger viele Spritzer aufweist, die grundsätzlich unerwünscht sind. Dieser Spritzeranteil wird meist bei der Angabe des Ionisierungsgrades des verdampften Materials nicht mit berücksichtigt, kann aber die Schichtqualität wesentlich beeinflussen. Man ist deshalb bestrebt, den Anteil der Spritzer im verdampften Material durch ein spezielles Quellenmagnetfeld oder zusätzliche Filter (mechanisch und elektromagnetisch wie in Aksenov, I.I. et al., Sov. J. Plasma Phys. 4(4) (1978) 425 erläutert) zu reduzieren oder durch andere Prozessparameter, wie beispielsweise einen erhöhten Reaktivgasdruck, zu verringern. Auch wird die Verwendung höherschmelzender Materialien vorgeschlagen, um die Spritzerzahl und -größe zu reduzieren.

Der ionisierte Anteil des verdampften Materials, den man bei der Funkenverdampfung beobachtet, kann auch zur Vorbehandlung von Substraten ausgenutzt werden. Mit einer sukzessiven Erhöhung der Substratbiasspannung kann deren Beschuss durch die Dampfionen des verdampften Materials und des Arbeitsgases so weit getrieben werden, dass die Substrate gesputtert werden oder/und auf hohe Temperaturen aufgeheizt werden können.

Gewöhnlich wird dieser Verfahrensschritt mit Metal-Ionen-Ätzen (metal ion etching) bezeichnet, eine etwas ungenaue Bezeichnung, da sie begrifflich nicht die Ionen einschliesst, die durch die übliche oder notwendige Verwendung eines Arbeitsoder Reaktivgases entstehen. Allgemein ist man aber bestrebt, den Anteil der Arbeitsgasionen (häufig wird ein Edelgas wie beispielsweise Argon verwendet) zu verringern oder das Arbeitsgas ganz zu vermeiden. Ein Grund dafür ist, dass Edelgase nicht stabil in Schichten eingebaut werden können, da sie nicht in Bindung gehen, und zusätzlich dazu zu Verspannungen führen. Im Allgemeinen ist aber ein kontinuierlicher Betrieb der Funkenquelle ohne Gaszugabe (Arbeitsgas oder Reaktivgas) nicht ohne weiteres möglich. Müssen Funkenquellen ohne Arbeitsgas betrieben werden, wie beispielsweise die Ionenquellen für die Ionenimplantation, werden diese gepulst betrieben, d.h. die Quelle muss immer wieder neu gezündet werden, da der Funken nur kurze Zeit "lebt", falls kein Gas beigegeben wird. Ein Beispiel eines solchen Betriebs wird in der JP 01042574 beschrieben.

Eine Vorbehandlung der Substrate mittels Ionenbeschusses und das damit zusammenhängende Ätzen des Substrates mittels Ionen sowie das Aufheizen des Substrates wurden schon in der US 4734178 beschrieben.

Es ist wichtig hier anzufügen, dass das Ätzen mittels Metallionen zu anderen Behandlungsresultaten an der Substratoberfläche führen kann, als es bei einem einfachen Aufheizen des Substrates der Fall ist oder auch bei einem Aufheizen des Substrates mittels Elektronenbeschusses wie es etwa in US 05503725 von Sablev beschrieben wird. Schon allein die Verwendung von Metallionen im Vergleich zu Edelgasionen ergeben neue Reaktionsmöglichkeiten, z. B. bei der Formierung von Karbiden oder Mischkristallen.

In der Literatur werden Kombinationen von Implantations- und Diffusionsvorgängen beschrieben, die zu einem Einbau der Metallionen in die Substratoberfläche und damit zu einer guten Ankopplung der später aufgedampften Schicht führen (Muenz, W.-D. et al., Surf. Coat. Technol. 49 (1991) 161, Schönjahn, C. et al, J. Vac. Sci. Technol. A19(4) (2001) 1415).

Problematisch bei diesem Prozessschritt ist aber vor allem die Existenz der metallischen Spritzer, deren Masse ein Vielfaches der Atommasse ist und die gewöhnlich nicht durch einen Ätzschritt wieder entfernt werden können, wenn sie auf die Substratoberfläche kommen und dort kondensieren.

Ein Ausweg aus dieser Situation besteht darin, die Funkenquellen mit Filtern auszurüsten, die die Spritzer von den Ionen trennen.

Ein bekanntes Filterdesign geht auf die Arbeiten von Aksenov, I.I. et al., Sov. J. Plasma Phys. 4(4) (1978) 425 zurück, wobei die Funkenquelle über eine Röhre, die ein Magnetfeld umschliesst, und die einen 90°-Winkel aufweist, an der Beschichtungskammer angeflanscht ist. Das Magnetfeld führt die Elektronen auf gekrümmter Bahn und diese zwingen wiederum die Ionen über elektrische Kräfte auf eine ähnliche gekrümmte Bahn. Die ungeladenen Spritzer aber prallen auf die Röhreninnenwand und werden somit daran gehindert, das Substrat zu erreichen. Für den Zweck des Metal-Ionen-Ätzens spielt der dabei entstehende Rateverlust eine untergeordnete Rolle. Von grossem Nachteil ist aber, dass der nutzbare Durchmesser des aus der Röhre in die Beschichtungskammer tretenden Ionenbündels nur wenige Zentimeter bis ca. 10 cm Durchmesser aufweist. Für viele Anwendungen bedingt das eine Bewegung des Substrates vor der Quelle, damit genügend Uniformität des Ätzprozesses gewährleistet werden kann. Das schliesst diese Methode für normale Batch-Beschichtungssysteme, wie sie für die Produktion üblich sind, aus.

Ein wesentlich einfacherer Ansatz ist das Arbeiten mit einer Blende vor der Funkenquelle und mit einer örtlich versetzten Anode, etwa hinter dem Substrat angeordnet (z. B. die Benutzung einer anderen Quelle als Anode auf der gegenüberliegenden Seite der Kammer), wie es auch schon bei Sablev US 05503725 prinzipiell geschildert, jedoch nicht speziell für den MIE-Prozess (MIE = Metal Ion Etching) beschrieben wurde. Der Weg der Elektronen führt dann durch die Kammer hindurch und an den Substraten gezwungenermassen vorbei. Durch die elektrischen Felder werden auch die Ionen auf die elektronennahen Wege gezwungen und stehen somit in Substratnähe für den Ätzprozess zur Verfügung. Die Spritzer werden vorwiegend an der Blende abgefangen. Diese Prozessführung wäre sehr ineffektiv für eine Beschichtung, da auch ionisiertes Material an der Blende und in den Randbereichen verloren wird. Doch da im Stand der Technik die typischen Prozesse für das Metall-Ionen-Ätzen nur kleine Ströme von einigen Ampere erfordern und nur für einige Minuten geätzt wird, kann ein solcher Betrieb für Produktionsprozesse durchaus gerechtfertigt werden. Bedingung für einen solchen Betrieb, der die Ionen auf die Elektronenbahnen durch den Substrathalter zwingt, ist allerdings eine von Kammerpotential separate Anode. Diese erfordert zusätzlich Platz in der Kammer, was wiederum die Produktivität der Anlage schmälert. Die oben zitierte zeitweise Nutzung einer anderen Funkenquelle als Anode hat den Nachteil, dass sich diese Quelle belegt und erst wieder nutzbar wird, wenn sie durch ein unerwünschtes "Freifunken" gereinigt wird.

Kurzum, es wäre wünschenswert, dass man beim MIE sowohl auf eine Blende verzichten könnte und den Betrieb der Funkenquelle nicht über eine separate Anode realisieren müsste, sondern die Funkenquellen mit der Substratkammer auf Anode (Masse) betreiben könnte, ohne dabei zu viele Spritzer, vor allem grossen Durchmessers, zu erzeugen, Ausserdem ist es wünschenswert zum Nullschichtwachstum auf dem Substrat bereits bei moderaten (kleiner 1500 V, bevorzugt kleiner 800 V) Substratbias zu gelangen und die Möglichkeit zu haben, über eine Veränderung des Substratbias aus der Beschichtungs- in die Ätzphase zu gelangen bzw. umgekehrt.

Wegen der Spritzerbildung im Funkenverfahren gibt es Bestrebungen, die Ionen nicht von einer Funkenquelle, sondern durch eine Sputterquelle zu erzeugen wie es in EP 01260603 beschrieben ist. Es ist bekannt, dass beim Sputterprozess weit weniger Spritzer erzeugt werden. Allerdings ist auch bekannt, dass gewöhnliche Sputterquellen weitaus weniger Ionen produzieren. Es konnte aber gezeigt werden, dass das Betreiben von Sputterquellen mittels gepulsten Stromversorgungen die Ionendichte während des Pulses wesentlich erhöht. Dieses "High Power Pulsed Magnetron Sputterverfahren" (HIPIMS) Ehiasarian, A.P. et al., 45th Annual technical Conference Proceedings, Society of Vacuum Coaters (2002) 328 scheint gut geeignet zu sein, um wesentlich mehr Ionen zu erzeugen, als es im normalen Sputterverfahren der Fall ist und vor allem eben auch metallische Ionen.

Von Nachteil bei diesem Verfahren ist allerdings, dass am Target ein wesentlich grösseres Magnetfeld notwendig wird, damit eine Magnetronentladung gezündet werden kann. Dieses stärkere Magnetfeld führt aber nachteiligerweise wieder dazu, dass die im hochenergetischen Puls erzeugten Ionen gefangen werden und nur ein kleiner Teil davon das Substrat erreicht.

Ein weit grösserer Nachteil dieses Verfahrens ist aber die Inkompatibilität des HIPIMS-MIE-Verfahrens mit der PVD Beschichtung in dem Sinne, dass man diese Quellen meist nicht für die eigentliche Beschichtung benutzen kann. Die Beschichtungsraten bei dem HIPIMS Verfahren sind so gering, dass in den meisten Fällen zusätzliche Quellen für eine Beschichtung eingesetzt werden müssen und man nicht auf die HIPIMS Quellen für eine Beschichtung zurückgegriffen werden kann. Das steht im Widerspruch zu einer Erhöhung der Produktivität bei den Produktionssystemen. Und schließlich benötigt das Sputterverfahren ebenfalls ein Edelgas, wie beispielsweise Argon als Arbeitsgas.

Die Nachteile der bis dahin verwendeten Methoden des Metal-Ionen-Ätzens: basierend auf der kathodischen Funkenverdampfung lassen sich wie folgt zusammenfassen:
1. Die ungefilterten Funkenquellen produzieren in Abhängigkeit vom Targetmaterial eine Vielzahl Spritzer, teilweise mit grossen Durchmessern. Diese Spritzer besitzen nicht genug Energie, um vollständig chemisch mit den Bestandteilen der Substratoberfläche zu reagieren oder in die Substratoberfläche eingebaut werden zu können.
2. Die Reduktion der Spritzer durch die Benutzung höherschmelzender Targetmaterialien erhöht die Materialkosten und erfordert höheren Aufwand bei der Betreibung des Funkens. Der Aufbau der Funkenquellen wird komplizierter, um die für die hochschmelzenden Materialien notwendigen höheren Quellenströme und Entladespannungen zu realisieren und die elektrischen Versorgungen verteuern sich ebenfalls.
3.Wegen der allgemein grösseren chemischen Trägheit (inertness) der höherschmelzenden Materialien, finden die wünschenswerten chemischen Reaktionen dieser hochschmelzenden Materialien mit den Bestandteilen der Substratoberfläche meist erst bei höheren Temperaturen statt (Beispiel Karbidformierung).
4. Die Kombination der Funkenquellen mit elektromagnetischen und/oder mechanischen Filtern zur Spritzerreduktion führt zu einem Verlust an Ionenstrom am Substrat. Noch wichtiger ist, dass die Uniformität einer solchen Behandlung nicht über grosse Substratbereiche, wie sie in Produktionssystemen üblich sind, gewährleistet werden kann.
5. Der Einsatz von Filtern hat neben den Verlust von Ionenstrom am Substrat auch noch eine Verringerung des Anteils mehrfach geladener Ionen zur Folge. Diese erhöhen die Wahrscheinlichkeit von chemischen (thermisch stimulierten) Reaktionen, da sie mit entsprechend mehrfacher Energie auf dem Substrat auftreffen und sind deshalb wesentlich an der Formierung hochtemperaturstabiler Verbindungen beteiligt. Den Verlust der mehrfach geladenen Ionen durch erhöhten Substratbias auszugleichen ist zwar denkbar, aber im Allgemeinen versucht man Spannungen über 1000 V zu vermeiden, um sowohl die Funkenbildung zu reduzieren, aber auch aus Sicherheitsgründen.
6.Höherer Prozessgasdruck führt zu einer Spritzerreduktion, aber reduziert auch den Substratstrom drastisch und wiederum vor allem den Anteil mehrfach geladener Metallionen. Aus Gründen der Prozesskompatibilität wäre es allerdings wünschendwert, auch genügend hohe Substrationenströme für den im Reaktivgas betriebenen Funken zu erreichen.

Die Nachteile des MIE basierend auf dem Sputterverfahren mittels HIPIMS lassen sich wie folgt zusammenfassen:
1. Keine Kompatibilität mit Funkenbeschichtungsquellen, weil die Beschichtungsraten zu klein sind, d.h. es benötigt spezielle Quellen und elektrische Versorgung für den Betrieb der Sputterquellen
2. Der Substrationenstrom wird nur im Puls generiert. Ein grosser Teil der Ionen wird durch das Magnetronmagnetfeld gefangen und gelangt nicht ans Substrat Muenz, W.-D. et al., Vakuum in Forschung und Praxis, 19 (2007) 12.
3. Der Betrieb der Sputterquellen setzt immer ein Arbeitsgas voraus, das in die Substratoberfläche eingebaut wird und zu meist unerwünschtem Stress und Instabilitäten in der Substratoberfläche führt.
4. Das Arbeiten mit Reaktivgas im Sputterbetrieb ist schwierig zu kontrollieren.

Aus dem oben Gesagten liesse sich mit Hinblick auf eine Anwendung des MIE folgende Schlussfolgerung ziehen:
Im wesentlichen sind es bei den Funkenquellen die grossen Spritzer, die Probleme bereiten, weil sie nicht genug Energie besitzen, um nach dem Auftreffen auf der Substratoberfläche noch ins Substrat zu diffundieren oder chemische Reaktionen mit den Bestandteilen der Substratoberfläche ausführen zu können. Ansonsten wäre die Funkenverdampfung mit ihrer Möglichkeit mehrfach geladene Ionen zu erzeugen, bestens dazu geeignet, um die Substratvorbehandlung mittels Metal-Ionen-Ätzens durchzuführen.

Aus Büschel, M. et al., Surf. Coat. Technol. 142-144 (2001) 665 ist weiterhin bekannt, dass Funkenverdampfungsquellen auch gepulst betrieben werden können, um Schichten abzuscheiden. In diesem Verfahren wird einem kontinuierlichen Haltestrom ein Pulsstrom überlagert. In diesem Zusammenhang wird auch erwähnt, dass das Pulsen der Quellen zu einer Reduktion der vor allem grossen Spritzer bei der Schichtabscheidung führt. Weiterhin ist aus der Literatur bekannt, dass das Pulsen der kathodischen Funkenquellen, ohne diese kontinuierlich zu betreiben, also bei jedem Puls immer wieder zu zünden, zu einem höheren Ionenstrom führt, der vor allem auf eine Erhöhung des Anteils mehrfach geladene Ionen zurückzuführen ist Oks, E.M. et al., Rev. Sci. Instrum. 77 (2006) 03B504.

Aufgabe der Erfindung ist es, eine Nullbeschichtungsrate trotz laufender Funkenbeschichtungsquellen, d.h. die Erzielung eines Gleichgewichtszustandes zwischen Materialaufbau und Materialabtrag an/auf die Oberfläche, und die Möglichkeit, diesen Gleichgewichtszustand durch den Substratbias zu steuern. Weiterhin ist es Aufgabe der vorliegenden Erfindung eine Substratvorbehandlung zu schaffen, die auf dem Beschuss der Substratoberfläche mit Ionen beruht, wobei diese zu einem wesentlichen Anteil aus Metallionen und Reaktivgasionen bestehen und im Extremfall vollständig auf ein Arbeitsgas verzichtet werden kann.

Ein weiteres Ziel dieser Erfindung ist das Eindiffundieren dieser Ionen in die Substratoberfläche und eine chemische Reaktion dieser Ionen mit Bestandteilen der Substratoberfläche.

Ein weiteres Ziel dieser Erfindung ist das Ausheilen von Substratveränderungen, die durch vorhergehende Schritte hervorgerufen wurden wie beispielsweise die Kobaltverarmung der Substratoberfläche durch die nasschemische Substratreinigung.

Die Aufgabe wird mit den Merkmalen des Anspruchs 1 gelöst. Vorteilhafte Weiterbildungen sind in Unteransprüchen gekennzeichnet.

Erfindungsgemäß wird von einem Verfahren ausgegangen zur Oberflächenbehandlung von Werkstücken in einer Vakuumbehandlungsanlage mit einer als Target ausgebildeten ersten Elektrode die Teil einer Arcverdampfungsquelle ist, wobei über der ersten Elektrode ein Funken mit Funkenstrom betrieben wird durch welchen Material vom Target verdampft wird welches sich zumindest teilweise und zeitweise auf den Werkstücken ablegt und mit einer zweiten Elektrode, die als werkstückhalterung ausgebildet ist und zusammen mit den Werkstücken eine Biaselektrode bildet, wobei an die Biaselektrode mittels einer Spannungsversorgung eine Biasspannung angelegt wird derart, dass die Biasspannung so mit dem Funkenstrom abgestimmt ist, dass netto im Wesentlichen kein Materialaufbau auf der Oberfläche stattfindet, wobei erfindungsgemäß die erste Elektrode mit gepulstem Strom betrieben wird, wobei das Pulsen zu einem gegenüber dem ungepulsten Betreiben erhöhten Substratstrom durch die Werkstücksoberfläche führt und dadurch bereits bei gegenüber ungepulsten Betreiben der ersten Elektrode niedrigerer Biasspannung netto kein Materialaufbau auf der Oberfläche stattfindet.

Das Betreiben von Vakuumbeschichtungsanlagen mit Funkenquellen mit gepusltem Strom ist bekannt. Beispielsweise beschreiben WO2006099760 und WO2007131944 das Betreiben der Funkenquelle mit gepulstem Strom als einen wesentlichen Faktor, die Kathodenfläche frei von undurchlässigen Oxidschichten zu halten und eine stabile Funkenentladung zu gewährleisten. Durch das Pulsen des Funkenstroms, zu dem spezielle Stromversorgungen notwendig sind, wird der Funken ständig auf neue Bahnen über das Target gelenkt und verhindert, dass er sich lediglich in bevorzugten Bereichen bewegt und die übrigen Targetbereiche sich mit dickem Oxid belegen, wie das beim geführten Funken ("steered arc") der Fall ist.

Das Pulsen des Stromes der Funkenquelle führt also teilweise zu einem ähnlichen Ergebnis wie es der Betrieb der Funkenquelle mit einem Magnetfeld bewirkt, nämlich zu einer Ablenkung des Funkens, die verhindert, dass dieser zulange an einem Ort bleibt und es zu grösseren Aufschmelzungen des Targets kommt und damit zu einer vermehrten Spritzerbildung. Vorteilhaft beim Pulsen gegenüber dem Betrieb mit einem Magnetfeld ist es aber, dass er nicht immer auf einer durch das Magnetfeld vorgegeben Bahn geführt wird, was vor allem beim Arbeiten mit Reaktivgasen zu Stabilitätsproblemen führen kann.

Der Pulsbetrieb der Funkenquellen kann sowohl als Pulsen des Stroms der einzelnen Funkenquelle wie auch als "Dual Pulsen" zwischen zwei Funkenquellen erfolgen. Während die erste Betriebsart nur (falls überhaupt) eine geringfügig modifizierte elektrische Versorgung gegenüber der normalen DC Versorgung voraussetzt und deshalb kostengünstig ist, erfordert das "Dual Pulsen" i.a. eine zusätzliche elektrische Versorgung, die zwischen zwei Quellen geschaltet ist, wie es aus WO2007131944 hervorgeht. Dafür erlaubt dieser Betrieb aber wesentlich höhere Frequenzen beim Pulsbetrieb, mit denen sich steilere Stromanstiege realisieren lassen.

Mittels der Erfindung können u.a. Schäden am Substrat ausgeheilt werden, die durch die Nassreinigung der Substrate (exsitu) bewirkt wurden. Dies bezieht sich insbesondere auf die Verarmung des Kobalts an der Substratoberfläche.

Die Erfindung bezieht sich ausserdem auf die Veränderung der Substratoberfläche durch den Einbau bzw. die chemische Reaktion von Atomen aus der Dampfphase mit Atomen/Bestandteilen in der äussersten Substratoberfläche mit dem Ziel, eine stabile Verbindung herzustellen, die weitaus bessere chemische, thermische und mechanische Stabilität gewährleistet.

Die Erfindung bezieht sich auch auf die Formierung einer dünnen Zwischenschicht in der Substratoberfläche, die eine innige Verbindung zwischen Substrat und aufzubringender Schicht herstellt und die zusätzliche Funktionen als Diffusionsbarriereschicht oder chemische Barriereschicht übernimmt.

Die Erfindung lässt sich auch zwischen Schichten mit verschiedenen Eigenschaften einsetzen, die sich nicht oder nur ungenügend durch einen Gradientenübergang herstellen lassen und für die ein möglichst dünnes Interface mit extrem guter Haftung erwünscht ist, z.B. zwischen so unterschiedlichen Materialien wie Oxiden, Karbiden, Nitriden und metallischen Schichten.

Besonderen Vorteil weist dieses neue Verfahren dort auf, wo oxidische Schichten mit metallischen Schichten, Metallkarbiden, Metallnitriden oder Metallkarbonitriden verbunden werden sollen. Das heisst, dass dieses Verfahren vor allem dort Anwendung findet, wo Schichten mit sehr unterschiedlichen Eigenschaften innig verbunden werden sollen, also beispielsweise bei der direkten Abscheidung von Oxidschichten auf Hartmetall oder im Übergang von Oxiden zu Nitriden bei Multilagenschichtsystemen.

Das neue Verfahren wird vorteilhaft auch dort angewendet, wo Schichten unterschiedlicher kristalliner Phasen gut haftend miteinander verbunden werden sollen.

Vor allem zielt diese Erfindung daraufhin ab, dass in der äussersten Substratoberfläche stabile Verbindungen zwischen den auftreffenden Ionen und den Bestandteilen der Substratoberfläche hergestellt werden, vor allem für jene Bestandteile der Substratoberfläche, die für sich selbst mechanisch oder chemisch instabil sind und zu Haftungsproblemen mit der später aufzubringenden Schicht führen.

Das heisst, dass die Erfindung weder ein übliches Ätzen noch ein Beschichten beschreibt, sondern eher ein Gleichgewicht zwischen diesen Prozessen und dass die Behandlung mit der Absicht durchgeführt wird, lediglich an und/oder in unmittelbarer Nähe zur Substratoberfläche chemische Reaktionen auszulösen und dass die Vorbehandlung quasi mit einem Nullwachstum oder nur sehr kleinen Schichtwachstum abzuschliessen ist.

Die viel grössere Masse des Ions im Vergleich zum Elektron in Verbindung mit der einstellbaren Ionenenergie über den Substratbias erlaubt ein chemisches Reagieren zwischen auftreffendem Ion und Substratbestandteil, was im Gleichgewichtszustand erst bei viel höheren Substrattemperaturen realisiert werden könnte. Das trifft auf die mehrfach geladenen Ionen in noch grösserem Masse zu.

Erfindungsgemäß wird eine wirtschaftliche Lösung realisiert, die in Produktionssystemen auf der Basis der Funkenverdampfungsquellen eingesetzt werden kann.

Mit der Erfindung können vor allem die makroskopischen Spritzer beim Betreiben der Funkenquellen reduziert werden. Hierbei besitzt das erfindungsgemäße Verfahren ein breites und leicht kontrollierbares Prozessfenster aufweist.

Die Erfindung wird anhand einer Zeichnung beispielhaft erläutert. Es zeigen dabei:
- Figur 1:: eine PVD-Beschichtungsanlage mit jeweils für sich ge- pulsten Funkenquellen;
- Figur 2a:: den DC-Funkenstrom;
- Figur 2b:: den gepulsten Funkenstrom;
- Figur 3a:: ein Substratstrom für den Fall des DC-Funkenstroms;
- Figur 3b:: den Substratstrom für den Fall des gepulsten Funken- stroms;
- Figur 4:: eine PVD-Beschichtungsanlage für das Dual-Pulse- Verfahren;
- Figur 5a:: den Funkenstrom der im DC-Betrieb durch eine Funken- quelle fließt;
- Figur 5b:: den Funkenstrom bei der Überlagerung der Funkenquelle mit bipolaren Pulsen;
- Figur 6a:: der Substrationenstrom im DC-Funkenbetrieb;
- Figur 6b:: den Substrationenstrom im bipolaren Betrieb;

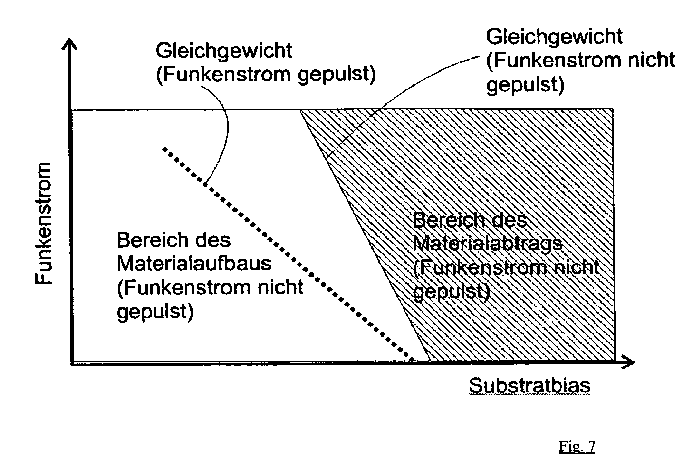

- Figur 7:: schematisch den Zusammenhang von Matarialauf- und- abbau abhängig von Funkenstrom und dem Substratbias;
- Figur 8:: eine Messwerttabelle für gepulsten Funkenstrom;
- Figur 9:: eine Meßwerttabelle für gepulsten Funkenstrom;
- Figur 10:: eine Tabelle zeigend den mittleren Ionenstrom und die Verdampfungsrate.

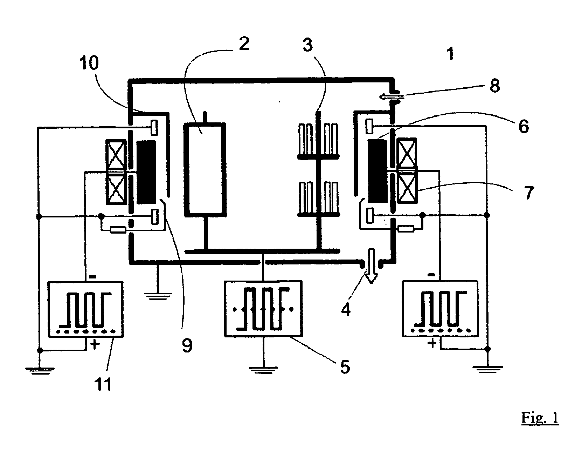

Um die Erfindung klar darstellen zu können ist es von Vorteil zunächst die Betriebsweise, in der jede Funkenquelle für sich gepulst wird und die schematisch in Figur 1 dargestellt ist, zu betrachten. Die Figur 1 zeigt ein PVD Beschichtungsanlage (1, batch system), wie sie zur Beschichtung unter Benutzung von Funkenquellen benutzt wird. Die Beschichtungsanlage 1 ist mit einem Pumpstand 4 (nicht gezeigt) verbunden, der in der Anlage das prozessbedingte Vakuum erzeugt. Die Substrathalterungen 2 und 3 dienen dazu, die Substrate (Werkzeuge oder Bauteile oder andere Komponenten) aufzunehmen und diese während der Vorbehandlung und der Beschichtung zu haltern. Die Substrathalterungen und damit die Substrate selbst, können während der Vorbehandlung und der Beschichtung mittels einer Substratbiasversorgung 5 auf eine Spannung gelegt werden, damit diese entweder Ionenbeschuss (negative Spannung) oder Elektronenbeschuss (positive Spannung) ausgesetzt werden. Die Substratbiasversorgung kann eine DC-, eine AC- oder eine bi- bzw. unipolare Substratspannungsversorgung sein. Die Beschichtung erfolgt mittels Funkenquellen. Diese Funkenquellen umfassen ein Target 6, dessen Material durch den Funken verdampft wird. Das durch die Magnete 7 hervorgerufene Quellenmagnetfeld bestimmt, ob ein Funken auf einer bestimmten Bahn geführt wird (sog. "steered arc"), um beispielsweise Spritzer zu reduzieren, oder ob der Funken sich mehr oder weniger frei auf der Targetoberfläche bewegen kann (sog. "random arc"), was meist eine besserer Targetausnutzung und eine höherer Verdampfungsrate zur Folge hat. Der Betrieb des Funkens kann in einem Arbeitsgas, das gewöhnlich ein Edelgas ist, erfolgen. Meist wird dazu Argon verwendet. Der Betrieb kann aber auch aus einer Mischung von Arbeitsgas und einem Reaktivgas oder auch allein im Reaktivgas erfolgen. Das Reaktivgas reagiert mit dem vom Funken verdampften Targetmaterial und bildet somit die entsprechenden Nitride, Oxide, Carbide und Mischungen daraus. Die Gase können entweder durch einen gemeinsamen Gaseinlass 8 oder durch verschiedene Gaseinlässe verteilt über die Anlage eingelassen werden und der Prozessdruck und die Gaszusammensetzung in der Behandlungskammer kann über Gasflussmeter gesteuert werden. Zum Zünden des Funkens auf dem Target kann entweder ein Zündfinger 9 oder eine andere elektrische Zündvorrichtung benutzt werden. Mit der Blende 10 kann das Target so abgeschlossen werden, dass trotz Funkenverdampfung kein verdampftes Targetmaterial zum Substrat gelangt. Der Funkenstrom zur Funkenverdampfung wird durch die Stromversorgung 11 geliefert. Gewöhnlich ist die Versorgung eine gewöhnliche DC Stromversorgung. Für die Experimente hier wurde eine gepulste Stromversorgung verwendet, wie sie auch beim Pulsschweissen üblich ist. Damit kann man einem konstanten DC Strom einen weiteren Pulsstrom überlagern. Von Bedeutung ist dabei, dass zwischen den Pausen der Strom nicht vollständig Null wird, sondern auf einer Grösse (Pausenstrom) verbleibt, der den Funken nicht verlöschen lässt.

Um den Effekt des Funkenstrompulsens auf den Substrationenstrom deutlicher untersuchen zu können, wurde in diesen Versuchen nur mit einer Quelle gearbeitet. Ohne auf dieses Material beschränkt zu sein, wurde zuerst ein Cr-Target für die Funkenverdampfung gewählt. Das Cr-Target wurde im Arbeitsgas Argon mit einem Argongasfluss von 300 sccm und mit einem DC-Quellenstrom von 140 A betrieben. Die Stromanstiegszeiten wurden konstant gehalten, indem eine Einstellung von 1000 A/ms an der Stromversorgung gewählt wurde. Der Substrationenstrom wurde in allen folgenden Experimenten für eine typische und unveränderte Substrathalterung, also als Total gemessen. Es muss hier angefügt werden, dass es zu einem kleinen Fehler bei der Messung des totalen (integralen) Stromes kommen kann, der dadurch entsteht, dass nicht alle Ionen an den Substrathalterungen aufgefangen werden und etwa auch auf die Kammerwand treffen. Aber für vergleichende Messungen und einer dichten Substratpackung kann dieser Fehler in Kauf genommen werden, weil angenommen wird, dass er nicht den generellen Trend der Messungen verfälscht, die hier nur als Relativaussagen verstanden werden sollen. Unter Benutzung eines DC Quellenstroms wurde damit ein mittlerer Ionenstrom am Substrat von 4.5 A gemessen (siehe Tabelle 1). Für den Fall des gepulsten Quellenstroms mit 600 A im Puls und mit der Pulslänge von 0.5 ms sowie 50 A in der Pulspause mit einer Pausenlänge von 3.4 ms wurde im Gegensatz dazu ein mittlerer Substrationenstrom von 7.8 A gemessen. Und das, obwohl der der zeitlich gemittelte Funkenstrom ebenfalls 140 A betrug. Der Ionenstrompeak am Substrat betrug in diesem Fall sogar 57.8 A.

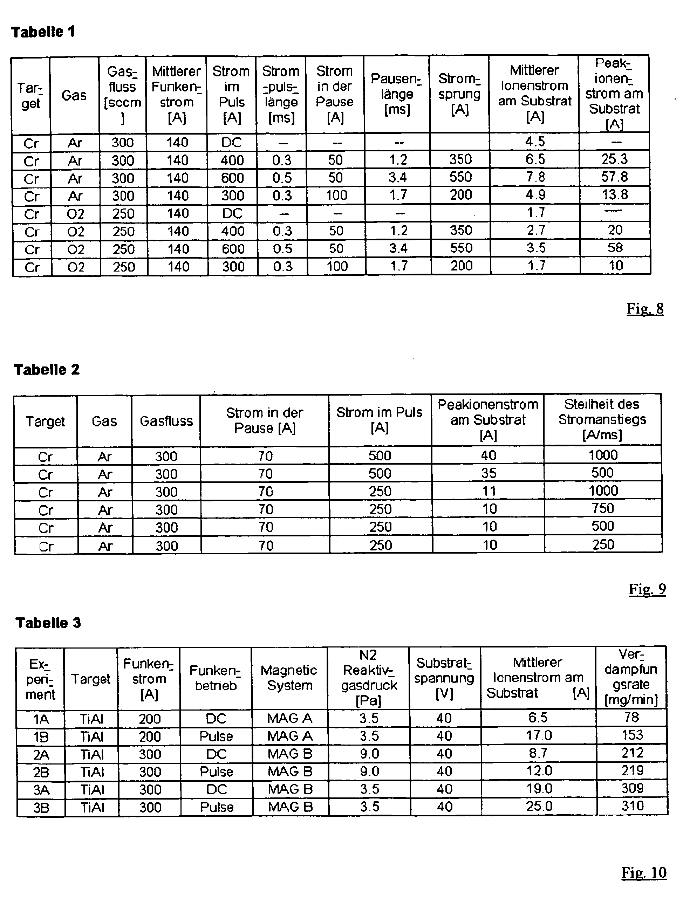

Aus der Tabelle 1 (Figur 8) lassen sich folgende Trends ablesen:
Das Pulsen des Funkenstroms führt zu einer Erhöhung des Substratstromes
Je grösser der Unterschied zwischen Pulsstrom und Pausenstrom, umso höher wird der Substratstrom, sowohl im zeitlichen Mittel wie im Puls.

Der Einfluss des Pulsens des Funkenstroms auf den Substratstrom wurde auch für den Betrieb der Funkenquellen im reinen Reaktivgas, in diesem Falle in Sauerstoff, untersucht. Als Vergleich wurde wieder der DC Betrieb der Funkenquellen herangezogen und es wurde mit Cr Targets und einem Sauerstofffluss von 250 sccm gearbeitet. Dafür ergab sich ein mittlerer Substrationenstrom von 1.7 A (ebenfalls Tabelle 1). Für den Fall des gepulsten Quellenstroms von 600 A im Puls mit der Pulslänge von 0.5 ms und 50 A in der Pulspause mit einer Pausenlänge von 3.4 ms, wurde im Gegensatz dazu ein mittlerer Substrationenstrom von 3.5 A gemessen. Wieder waren die mittleren Funkenströme für DC und Pulsen gleich, nämlich 140 A. Der Ionenstrompeak am Substrat betrug in diesem Fall 58 A. Für den Betrieb im Reaktivgas kann man wieder gleiche Trends ablesen wie sie für den Betrieb in Argon bestehen. Zusätzlich sieht man, dass beim Betrieb im reinen Sauerstoff verglichen mit dem Betrieb im Argon der Substratstrom kleiner wird. Ein Pulsen der Funkenquellen kann dieses zumindest teilweise kompensieren und erlaubt somit einen hohen Substratstrom, selbst beim Arbeiten im reinen Reaktivgas, also unter Verzicht auf das Arbeits(Edel)gases, was ja vorteilhaft für die hier diskutierte Vorbehandlung ist.

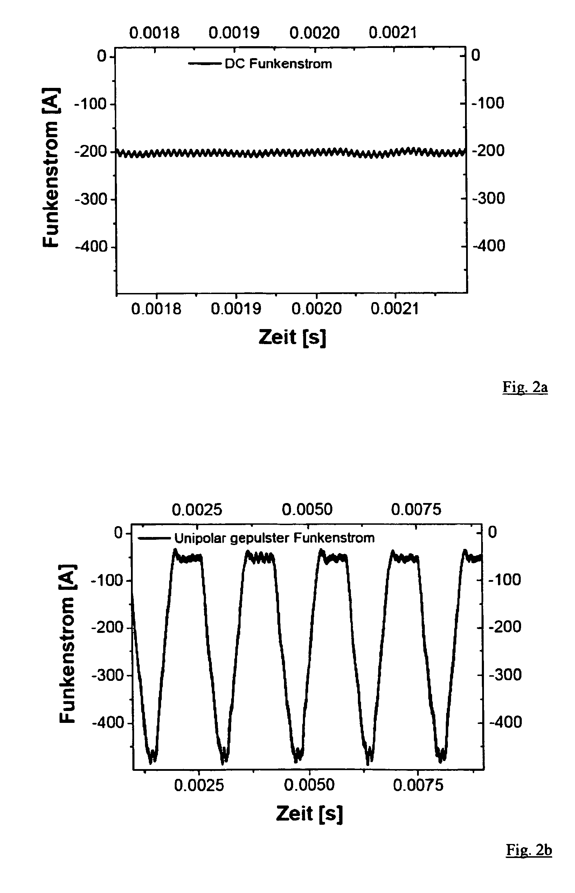

Um zu zeigen, dass dieses Verhalten nicht nur für elementare Targets gilt, sonder auch für Legierungstargets, wurden weitere Versuche mit Al-Cr-Targets durchgeführt, hier als Beispiel für ein Target bestehend aus Al/Cr mit einer Zusammensetzung von 70at%/30at%. Wieder wurde der DC Funkenbetrieb mit dem gepulsten Funkenbetrieb verglichen. Es wurde mit einem mittleren Funkenstrom von 200 A in reiner Sauerstoffatmosphäre bei einem eingestellten Sauerstofffluss von 400 sccm gearbeitet. Als Vergleich wurde anschliessend der Funkenstrom gepulst zwischen 50 A in der Pause und ca. 470 A im Puls. Dieser Pulsstrom liefert wieder ein zeitliches Mittel von 200 A, ist also vergleichbar mit dem DC Funkenstrom. In den Abbildungen 2a und 2b sind die zeitlichen Verläufe dieser beiden Ströme dargestellt, wobei hier der Funkenstrom willkürlich negativ aufgetragen wird. Figur 2a zeigt den DC Funkenstrom und Figur 2b zeigt den gepulsten Funkenstrom.

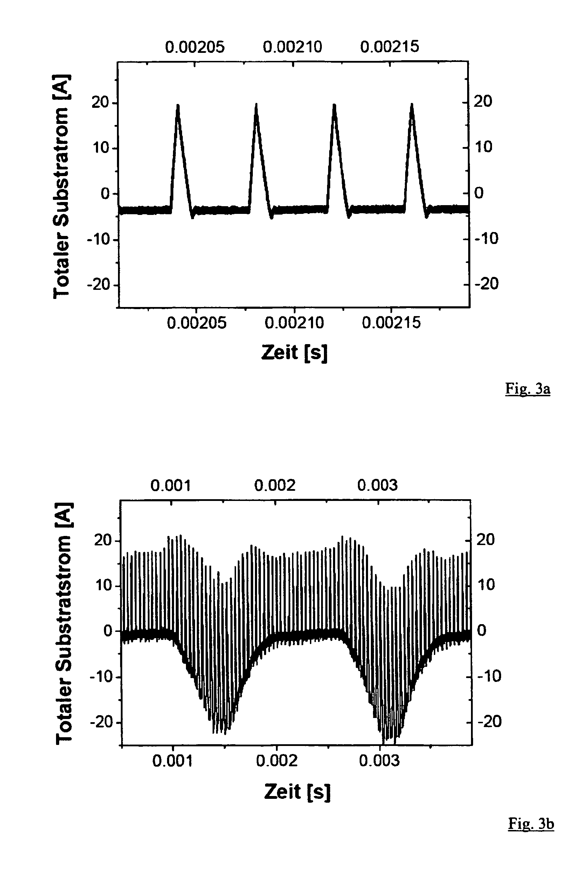

Die für diesen Betrieb gemessenen totalen Substrationenströme sind in den Abbildungen 3a und 3b dargestellt, wobei hier der Ionenstromanteil des Substratstroms negativ, der Elektronenstrom positiv aufgezeichnet wurde. Figur 3a zeigt den Substratstrom für den DC Funkenstrom Fall, Figur 3b zeigt den Substratstrom für den AC Funkenstrom Fall.

Da das Betreiben eines Al/Cr-Targets in Sauerstoffatmosphäre zur Bildung von Oxidschichten führt, wurde am Substrat mit einem bipolaren Substratbias gearbeitet (ca. 25 kHz). Während des DC Betriebs kann man deutlich den Ionenstrom (negativ dargestellt) vom Elektronenstrom (positive Achse) unterscheiden. Integriert man über den Substrationenstrom (also über den negativ dargestellten Strom), so erhält man ein zeitliches Mittel von 2.8 A. Für den Betrieb mit gepulstem Funkenstrom spiegelt sich die Überlagerung der Funkenstromfrequenz (ca. 700 Hz) mit der Pulsfrequenz des Substratbias im Stromverlauf des Substratstromes wider. Mittelt man hier ebenfalls über den Substrationenstrom (negativer Wertebereich), so ergibt sich ein mittlerer Ionenstrom von 4.9 A, d.h. man kann fast eine Verdoppelung des Substrationenstroms durch Pulsen der Funkenquelle erzielen.

In dem angegebenen Beispiel wird ein Betrieb von Quellenversorgung und Substratbiasversorgung beschrieben, bei dem beide Versorgungen nicht synchronisiert sind. Die Frequenz der Substratbiasversorgung ist mit ca. 25 kHz wesentlich höher als diejenige der Quellenstromversorgung (ca. 700 Hz). Vernünftige Pulsfrequenzen der Quellenstromversorgung liegen zwischen 1Hz und 5kHz. Vorzugsweise kommen Pulsfrequenzen zwischen 500Hz und 2kHz zur Anwendung. Diese Überlagerung sieht man auch im Substratstrom während des Pulsens des Quellenstroms. Der bipolar gepulste Bias verringert ein wenig den gesamten Substratstrom gegenüber DC-Bias.

Eine drastische Erhöhung des Substratstroms im Pulspeak (nicht aber im zeitlichen Mittel) erhält man, falls man die beiden Versorgungen synchronisiert. D.h. für die Frequenz der Biasspannung wählt man eine dem Quellenstrom entsprechende Frequenz oder ein ganzzähliges Vielfaches davon. Im negativen Peak sollte die Biasspannung allerdings derart gegenüber dem Peak des Quellenstroms zeitlich verschoben sein, dass die Flugzeit der Ionen vom Target zum Substrat berücksichtigt wird. Dieser Betrieb ist für das MIE von Vorteil da dabei kurzzeitiger Ionenbeschuss mit sehr grossen Energien zu erzielen sind. Dies bedeutet aber etwas Mehraufwand für die Synchronisation der Versorgungen, vor allem für den Betrieb in Batch-Systemen mit unterschiedlichen Beladungen. Deshalb wird im Allgemeinen auf eine Synchronisation verzichtet, wenn es zu keinen markanten Nachteilen im Prozess führt.

Zusammenfassend zeigt das Ergebnis, dass es wesentlich einfacher ist, im gepulsten Betrieb der Funkenquellen, die Abtragsrate bei etwa gleicher Verdampferleistung, die durch den mittleren Strom definiert wird, drastisch zu erhöhen und somit in den Nullschichtwachstumsbereich zu gelangen.

Zudem wird aus dem oben Gesagten auch deutlich, dass man im Bereich des Nullschichtdickenwachstums mit der Einstellung des duty-cycles der bipolaren Substratbiasversorgung noch einen zusätzlichen Parameter zur Verfügung hat, um aus dem Ätzbereich in den Beschichtungsbereich zu gelangen, und zwar unter Beibehaltung der gleichen Substratspannung. Im erfindungsgemässen Verfahren kann der Substratbias als DC Spannung betrieben werden. Ein AC Betrieb reduziert zwar in der Regel den Substratstrom geringfügig, allerdings kann dadurch effektiv verhindert werden, dass vom Substrat aus ein unerwünschter Funken gezogen wird. Insbesondere helfen kleine duty-cycle eine derart unerwünschte Funkenbildung zu verhindern.

Bis hierher wurde gezeigt, dass für elementare und Legierungstargets der Pulsbetrieb der Funkenquellen im Edelgas wie im Sauerstoff zu einer Substrationenstromerhöhung führt. Im Folgenden soll noch in einem weiteren Experiment der Betrieb der Funkenquellen im reinen Stickstoffreaktivgas untersucht werden. Die dazu gehörenden Experimente sind in Tabelle 3 zusammengefasst. Zuerst wurde für einen Funkenstrom von 200 A der DC mit dem gepulsten Betrieb verglichen. Die im Beispiel verwendeten Ti/Al Targets (ohne Einschränkung des Targetmaterials und dessen Zusammensetzung) besitzen ein Zusammensetzung des Ti/Al von 50at%/50at%. Der Stickstofffluss wurde während der Funkenverdampfung so geregelt, dass sich in der Beschichtungskammer ein Prozessdruck von 3.5 Pa einstellte. Für den DC Betrieb ergab sich dabei ein Substratstrom von 6.5 A. Im Falle des Pulsbetriebs konnte für den gleichen mittleren Funkenstrom von 200 A ein Substrationenstrom von 17 A erreicht werden. Diese Versuche wurden mit einem Targetmagnetfeld (MAG A) durchgeführt, das stark genug ist, um den Funken auf vorbestimmte Bahnen zu führen, um einen so genannten "steered arc"zu erzwingen. Es ist dem Fachmann bekannt, dass ein solcher Betrieb zu einer drastischen Reduktion der Spritzer führt, weil der Funken weniger lang an einem Ort bleiben und damit die Schmelze im Funkenbereich klein gehalten werden kann. An diesem Beispiel wird wiederum deutlich, dass es über den Pulsbetrieb möglich ist, den Substrationenstrom zu erhöhen und diesen dazu zu benutzen, um ein Nullschichtdickenwachstum schon bei moderaten Substratbiasspannungen zu erzielen.

Mit den gleichen Targets wurden bei höherem Funkenstrom Prozesse gefahren, um den Einfluss des Reaktivgasdrucks auf den Substrationenstrom zu untersuchen. Dafür wurde ein schwaches Targetmagnetfeld (MAG B) benutzt, das den Funken nicht auf eine bestimmte Targetbahn zwingt (random arc). Für den Betrieb in einem Stickstoffdruck von 9 Pa konnte der Substrationenstrom von 8.7 A auf 12 A erhöht werden. Bei einem Druck von 3.5 Pa wurde der Substratstrom von 19 A auf 25 A erhöht. Wieder wird der positive Einfluss des gepulsten Funkenstroms auf eine Erhöhung des Substrationenstroms deutlich.

Wenn man jetzt noch einmal das Ziel des Verfahrens diskutiert anhand der Ergebnisse aus Tabelle 3 (Figur 10), so kann man folgendes zusammenfassen:
Auch im Reaktivgas Stickstoff führt der Pulsbetrieb der Funkenquellen zu einer Erhöhung des Substrationenstroms
Die Erhöhung de Substratstroms ist viel stärker ausgeprägt für den Fall des gesteuerten Funkens (steered arc) im Vergleich zum random arc.
Für den gesteuerten Funken erhöhen sich durch das Pulsen sowohl Verdampfungsrate wie Substrationenstrom, aber die Erhöhung des Substrationenstroms ist relativ grösser.
Für den ungesteuerten Funken (random arc) verändert sich die Verdampfungsrate nur unwesentlich, aber der Substrationenstrom wächst deutlich.
Zusammenfassend kann man auch hier sagen, dass der Pulsbetrieb dazu beiträgt, Nullschichtwachstum schon bei geringerem Substratbias zu erreichen, weil der Substrationenstrom erhöht werden kann.

Mit Bezug auf die Ergebnisse aus Tabelle 1 lässt sich vermuten, dass auch die Steilheit des Stromanstiegs beim Pulsen einen Einfluss auf den Substratstrom haben könnte. Diese wurden deshalb untersucht und die Ergebnisse zu diesen Untersuchungen sind in Tabelle 2 wiedergegeben. Es wurde immer vom gleichen Funkenstrom während der Pause ausgegangen (70 A) und dann auf den Pulsstrom gesprungen. Für den Sprung wurden an der Stromversorgung verschiedenen Steilheiten eingestellt. Gemessen wurde der Substratpeakionenstrom in Funktion der unterschiedlichen Steilheiten des Pulses und in Funktion des Pulsstroms. Vergleicht man die Zeilen 1 und 2 aus der Tabelle, sieht man, dass eine grössere Steilheit beim Puls zu einer Vergrösserung des Substratpeakionenstroms von 35 A auf 40 A resultiert. Weiter kann man aus der Tabelle 2 herauslesen, dass die Steilheit des Stromanstiegs erst ab ca. 1000 A/ms zu einer wesentlichen Erhöhung im Substrationenstrom führt. Kleinere Anstiegszeiten zwischen 250 A/ms und 750 A/ms haben kaum noch Einfluss.

Basierend auf diesem Ergebnis ist es verständlich, dass eine Erhöhung der Stromanstiegszeiten wesentlichen Einfluss auf eine Erhöhung des Substratstroms haben kann. Technologisch ist das aber schwierig, falls das mit Stromversorgungen realisiert werden soll, die als gepulste Stromversorgungen eingesetzt werden wie es in Abbildung 1 dargestellt ist. Bei den heute kommerziell erhältlichen Stromversorgungen würde schon eine Vergrösserung der Stromanstiegszeiten auf ca. 50000 A/ms, also um einen Faktor 50 des in der Tabelle 2 (Figur 9) angegebenen grössten Wertes, einen grossen technischen und finanziellen Aufwand erfordern bzw. überhaupt schwer realisierbar sein. Zudem kommt noch, dass bei diesen Stromanstiegszeiten die Kabelimpedanzen der Stromzuleitungen eine wesentliche Rolle spielen und die Pulsform beeinflussen, d.h. die Steilheit reduzieren.

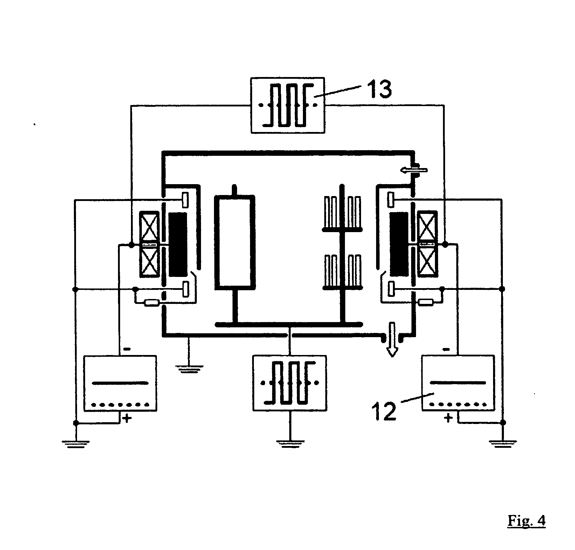

In Abbildung 4 ist nun ein Prozessansatz ("Dual Pulse Verfahren") angegeben, der sich eignet, um sehr grosse Pulsfrequenzen auch für grosse Ströme zu realisieren. In diesem Ansatz wird eine bipolare Spannungs- oder Stromversorgung (13, nicht zu Verwechseln mit der bipolaren Substratbiasversorgung!) zwischen zwei Funkenquellen betrieben, welche zusätzlich jeweils durch gewöhnliche DC Stromversorgung (12) gespeist werden. Der Vorteil einer solchen Anordnung besteht darin, dass die bipolare Versorgung im vorionisiertem Plasma der beiden Funkenverdampfungsquellen betrieben wird. Das ermöglicht ein sehr schnelles Pulsen des Plasmas mit Frequenzen im Bereich einiger hundert Kilohertz und erlaubt Ströme, die im Wesentlichen in ihrer Grösse den Strömen der Quellenversorgungen entsprechen. Die Grösse des bipolaren Stromes der Versorgung 13 muss lediglich so angepasst sein, dass der resultierende Gesamtstrom durch die Funkenquelle nicht unter dem Haltestrom liegt, d.h. der Funken nicht verlischt, sondern kontinuierlich betrieben werden kann.

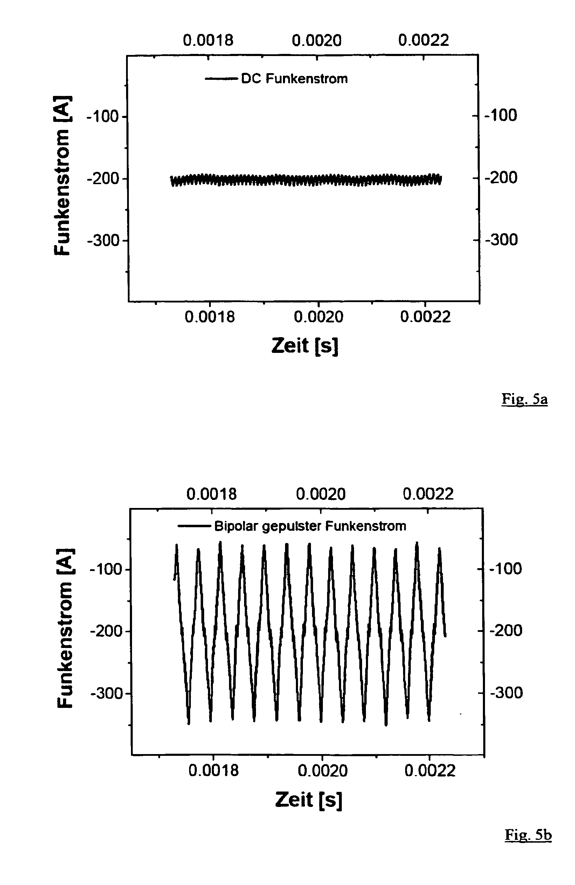

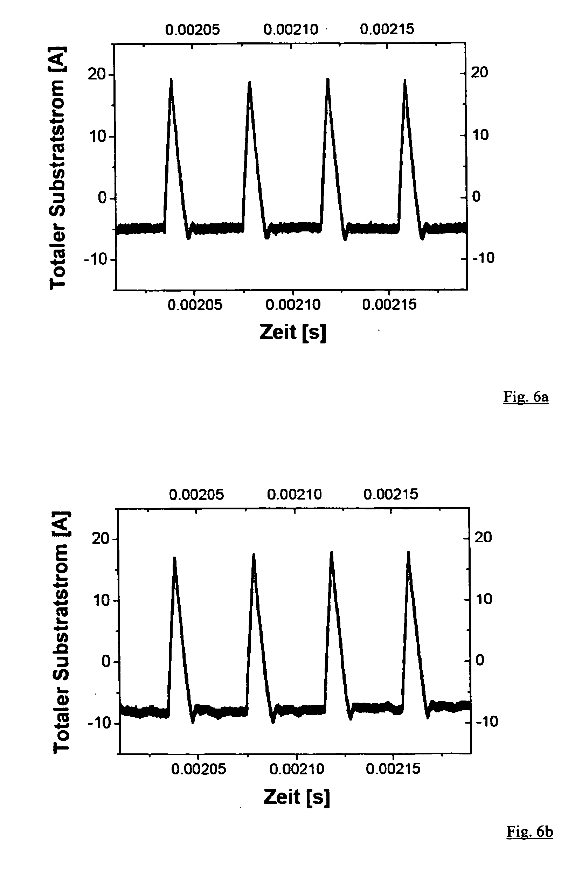

Im Beispiel in Abbildung 5a ist wieder der Funkenstrom, der im DC Betrieb durch eine Funkenquelle fliesst, dargestellt. Es wurde mit 200 A gearbeitet und wieder im reinen Sauerstoffreaktivgas und wieder mit Targets aus Al/Cr der Zusammensetzung 70at%/30at%. In Abbildung 5b ist der Funkenstrom dargestellt, falls die Funkenquelle mit bipolaren Pulsen überlagert wird und man erkennt das Pulsen des Funkenstromes zwischen 50 A und 350 A mit einer Frequenz von 25 kHz. Dies entspricht einem zeitlichen Strommittelwert von 200 A. Verglichen wurde wieder der entsprechende Substrationenstrom beim DC Funkenbetrieb (Abbildung 6a) mit dem des bipolaren Betriebs (Abbildung 6b). Die Stromanstiegsgeschwindigkeiten sind hier frequenzbedingt und liegen bei dieser Frequenz in der Grösse von 10⁶ A/s. Diese Stromanstiegsgeschwindigkeit kann aber problemlos noch weiter erhöht werden durch eine Erhöhung der Frequenz auf 100 kHz oder 500 kHz.

Das "Dual Pulsen" der Quellen resultiert ebenfalls in einem deutlichen Anstieg des Substratstroms, wie aus dem Vergleich der Abbildung 6a und 6b folgt. Der mittlere Substrationenstrom erhöht sich von 3.8 A beim DC Betrieb der Funkenquellen auf 6 A beim Pulsen, also um etwa 50 %.

Aus der bisherigen Beschreibung geht hervor, dass eine Substrationenstromerhöhung allein durch die Änderung der Pulsparameter erfolgen kann, also elektrisch einfach einstellbar ist und ein Parameter, der keine Änderung etwa der Biasspannung oder des Quellenstroms oder des Gasdrucks voraussetzt und demzufolge frei wählbar ist. Die Prozessansätze sind einfach zu realisieren mit den entsprechenden Versorgungen und es benötigt keine zusätzlichen Quellen im System, sondern es können die üblichen Funkenquellen verwendet werden. Man kann auf das Arbeitsgas verzichten und nur im Reaktivgas arbeiten.

Beide Betriebsarten des Pulsens der Funkenquellen wurden nun zur Substratvorbehandlung eingesetzt. Da die Verdampfungsraten des Kathodenmaterials sich für beide Betriebsweisen nicht wesentlich von den DC Verdampfungsraten unterscheiden (zumindest im random arc Betrieb), ist zu vermuten, dass es vor allem mehrfach geladenen Metallionen sind, die mit dem Pulsen der Funkenquellen erzeugt werden und dass dadurch der Substratstrom erhöht wird. Diese Vermutung wird auch durch Veröffentlichungen bestärkt Oks, E.M. et al., Rev. Sci. Instrum. 77 (2006) 03B504. Allerdings kommt es auch zu einer zusätzlichen einfachen Ionisierung, vor allem des Reaktivgases, wenn die Funkenquellen gepulst werden.

Die Erhöhung des Substrationenstromes, ohne dass es zu einer wesentlichen Erhöhung der Verdampfungsrate kommt, ermöglicht eine bessere Ätzeffizienz. Das bedeutet, dass mit gleichem Bias am Substrat schneller geätzt werden kann oder dass man mit geringerem Bias die gleiche Ätzrate erzielt. Beim DC Betrieb der Funkenquellen mit einem Strom von 120 A wird beispielsweise eine Ätzrate von 14 nm/min auf Substraten mit 2-facher Rotation erzielt, falls mit einem Substratbias von 800 V gearbeitet wird. Bei einem Bias von 300 V ist man unter diesen Bedingungen etwa im Bereich des Gleichgewichts zwischen Beschichtung und Ätzen.

Falls man über die Pulsparameter bei gleichem mittlerem Funkenstrom eine Erhöhung des Substrationenstroms um 50% einstellt, erhöht sich die Ätzrate auf 23 nm/min beim Substratbias von 800 V oder es kann mit einem Substratbias von etwa 200 V gearbeitet werden, um im Gleichgewicht zwischen Beschichtung und Ätzen zu arbeiten.

Ausserdem hat man die Möglichkeit, den duty-cycle an der Substratbiasversorgung so zu ändern, dass man beispielsweise bei 800 V arbeitet, aber nur mit 50% duty cycle und auf diese Art das Gleichgewicht zwischen Ätzen und Beschichten auch bei höheren Spannungen erzielt, also bei hohen Ionenenergien, und so Vorgänge an der Substratoberfläche steuert, die ionenenergieabhängig sind.

Da die rechnerische Abschätzung der Ätzraten für Produktionsbatches schwierig ist, empfiehlt es sich für eine vorgegeben Verdampferleistung das Gleichgewicht zwischen Beschichten und Ätzen zu ermitteln. Eine wesentliche Verbesserung der Haftung von PVD Schichten wurde schon für eine Substratvorbehandlung von 3 min erzielt. Dabei wurde die Haftung mit dem Fachmann bekannten Scracht-Test gemessen (mit Bezug auf ISO 1071, ASTM G171).

Das Pulsen der Quellen erhöht aber nicht nur den Substratstrom, es wirkt sich auch auf die Bewegung des Kathodenflecks aus und es kommt mit dem Pulsen zu einer Ablenkung des Kathodenflecks. Die starken Stromänderungen während des Pulsens bewirken elektromagnetische Felder, die hinreichend gross sind, um den Funkelauf zu beeinflussen. Positiv daran ist vor allem eine Verringerung der Anzahl vor allem der grossen metallischen Spritzer, was in der kürzeren Verweilzeit des Funkens an einem Ort seine Ursache hat.

Vorteilhaft ist die Erhöhung des Substrationenstromes auch noch unter dem Gesichtspunkt, dass mit kleineren mittleren Quellenströmen gearbeitet werden kann. Es ist dem Fachmann bekannt, dass eine Verringerung des Quellenstroms auch mit einer Spritzerreduktion einhergeht.

In WO2006099760 wurde das Pulsen des Quellenstroms beschrieben, um den geführten Funken für eine Oxidbeschichtung nutzbar zu machen. Um zu verhindern, dass der Funken nur auf der geführten Bahn läuft und die Targetfläche ausserhalb dieser Bahn vollständig aufoxidiert und es damit zu Instabilitäten im Funkenbetrieb kommt, wurde der Funken gepulst. Das Resultat war, dass eine Aufoxidation des Targets ausserhalb der Fläche für den geführten Funken vermieden wurde. Kombiniert man nun auf gleiche Weise den geführten Funken mit dem Pulsen, kann man folgendes experimentell beobachten:
- der geführte Funken besitzt eine kleinere Verdampfungsrate des Targetmaterials, jedoch mit stark reduzierter Spritzerhäufigkeit
- das Pulsen des geführten Funkens führt zwar zu einer Erhöhung der Verdampfungsrate des Targetmaterials, aber zu einer weit grösseren relativen Erhöhung des Substrationenstroms.

Auf diese Weise lassen sich Bedingungen realisieren, die ideal sind zur Vorbehandlung von Substraten und wobei die Spritzerhäufigkeit drastisch reduziert wird.

Wie schon weiter oben angedeutet wurde, eignet sich die kathodische Funkenverdampfung hervorragend für reaktive Prozesse. Im Unterschied zu den Sputterverfahren ist die Regelung des Reaktivgases sehr einfach und es kann im Reaktivgasüberfluss gearbeitet werden, ohne dass es zu Targetvergiftungen kommt. Ausserdem kann man bei Reaktivgasprozessen auf ein Arbeitsgas wie Argon verzichten und im reinen Reaktivgas wie Stickstoff oder Sauerstoff arbeiten. Damit besteht keine Gefahr des Einbaus eines Edelgases in die Substratoberfläche. Dadurch wird sowohl die Schwächung der Substratoberfläche durch Stress vermieden, aber auch Instabilitäten vorgebeugt, die in der Diffusion oder Einbaus des Edelgases in die Schicht begründet sind.

Durch das Pulsen der Quellen im Reaktivgas werden neben den Metallen auch die Reaktivgase ionisiert und diese können ebenso dazu benutzt werden, um die Substratoberfläche zu "behandeln". Es soll hier bewusst nicht von einem Ätzschritt gesprochen werden, da, wie schon eingangs gesagt, das Ziel der Vorbehandlung weder ein wesentlicher Materialabtrag noch ein wesentliches Schichtwachstum ist. Der Prozess wird gerade so eingestellt, dass eine Art Gleichgewicht zwischen Ätzen und Beschichten gewährleistet ist und dass es zum Ionenbeschuss kommt, der möglichst viel Energie in die Substratoberfläche einbringt, um die Metallionen einzudiffundieren, zu implantieren bzw. reagieren zu lassen mit "instabilen" Substratkomponenten an der Oberfläche.

Die Kontrolle des Prozesses ist nicht problemlos, vor allem nicht in Batch-Systemen und unter Produktionsbedingungen. Eine Änderung der Beladung führt prinzipiell zu einem neuen Beschichtungs-Ätz-Verhältnis. Zudem gilt es noch zu berücksichtigen, dass Substrate an scharfen Kanten ein grösseres elektrisches Feld aufweisen, das zu verstärktem Ätzen führt. Auch aus diesem Grunde ist es vorteilhaft wenn der von den Quellen generierte Dampf möglichst grosse Anteile an Ionen enthält, vor allem höher geladene, damit die Quellen leicht im Bereich der Nullbeschichtung betrieben werden können unter der Randbedingung, dass schon ein vergleichbar kleiner Substratbias dafür hinreichend ist.

Das Metallionenätzen ist theoretisch zumindest mit Hinblick auf die mehrfach geladenen Ionen, die im gepulsten Betrieb der Funkenquellen entstehen, nicht ausreichend untersucht, um die Sputtereffekte mit den Diffusionsvorgängen, einer Implantationen in die äusserste Substratoberfläche und den Reaktionen der vor allem mehrfach geladenen Ionen an den Substratoberflächen genau gegeneinander abwägen zu können. Rein empirisch kann man aber im Resultat des Prozesses eine markant verbesserte Haftung von PVD Schichten auf metallischen Substraten beobachten. Das trifft besonders auf HSS und besonders auf Hartmetallsubstrate zu.

Bei der Anpassung der Prozessparameter für die Substratvorbehandung, wurde deshalb immer in einem ersten Schritt eine Kalibrierung in der Art vorgenommen, dass für ein bestimmtes Targetmaterial der Quellenstrom, die Pulsform des Quellenstroms, das Quellenmagnetfeld, der Substratbias, der Arbeitsgasdruck und/oder der Reaktivgasdruck ein Prozessfenster so festgelegt wurde, dass über eine Zeit zwischen 30 s und 10 min je nach Beladung der Anlage kein oder lediglich ein Schichtwachstum von weniger als 20 nm auf den Substraten gemessen wurde. Dazu wurden nicht nur metallischen Substrate, sondern für Analysenzwecke auch Silizumwafernstückchen in der Anlage behandelt. Auf den Siliziumwafern ist es besonders einfach mittels der dem Fachmann bekannten RBS Analyse auch geringe Schichtdicken auszumessen.

Meist wurde dabei so vorgegangen, dass ein möglichst kleiner Quellenstrom mit möglichst steilen Pulsen betrieben wurde, um eine hohe Ausbeute an mehrfach geladenen Ionen zu erhalten. Dann wurden die Schichten ausgemessen, die bei einem solchen Betrieb der Quelle(n) und für verschiedene Biasspannungen, typisch zwischen 40 V und 1200 V, gemessen wurden. Aus der so erhaltenen Abhängigkeit wurden die Prozessparameter so gewählt, dass man etwa Nullwachstum (± 5 nm) am Substrat einstellte.

Von Bedeutung scheint bei dieser Art der Substratvorbehandlung die Möglichkeit, über die in die Substratoberfläche eingebrachte hohe Energie der vor allem mehrfach geladenen Ionen chemische Reaktionen mit den Komponenten des Substrates zu erzielen oder Diffusionsvorgänge in der Nähe der Substratoberfläche auszulösen.

Von besonderer Bedeutung, aber ohne Einschränkung, soll hier die Formierung eines Karbides mit den Ionen einer Targetquelle aus Chrom besprochen werden. Im Falle des herkömmlichen Ätzprozess mit Argongas wird darauf abgezielt, dass Material von der Substratoberfläche abgetragen wird, damit lose Bestandteile der Substratoberfläche, beispielsweise die Rückstände eines Polierverfahrens, entfernt werden, bevor mit der eigentlichen Beschichtung begonnen wird. Dieses herkömmliche Verfahren wird man in den meisten Fällen beibehalten, ehe man mit der eigentlichen und eher kurzen hier beschriebenen Substarvorbehandlung beginnt, denn es ist einleuchtend, dass diese nur Sinn macht, wenn die gröbsten Rückstände an der Substratoberfläche von Resten anderen Materials beseitigt worden sind. Im Schritt der Substratvorbehandlung der hier von Interesse ist, kommt es natürlich auch zu Sputterprozessen, wenn mehrfach geladene Chromionen auf die Substratoberfläche auftreffen. Aber durch den mehrfachen Eintrag an Energie der mehrfach geladenen Ionen kommt es gleichzeitig auch zu chemischen Reaktionen. Es ist aber wie schon erwähnt, nicht der Materialabtrag Ziel der Substratvorbehandlung in dieser Erfindung, sondern das Fördern einer chemischen Reaktion. Haben nun die Chromionen genügend hohe Energie, so kann es beispielsweise in einem Hartmetallsubstrat (Wendeschneidplatte), das vorwiegend aus Wolframcarbid und kleinen Mengen elementaren Wolframs und Kohlenstoffs besteht und typischerweise zudem noch Cobalt als Binder enthält, zur Bildung von Cromcarbiden und/oder zur Bildung von Mischkristallen aus Cr, Co und W kommen. Je grösser der Anteil der Chromionen, umso wahrscheinlicher ist eine Karbidbildung. Einen grossen Beitrag liefert der Anteil der mehrfach geladenen Ionen, weil diese ja eben das Mehrfache an Energie einbringen und damit ins Substrat eindringen können und mit auch etwas tiefer liegenden Bestandteilen reagieren können.

Eine Phasenanalyse mittels X-TEM ergab die Existenz karbidischer Phasen mit Chrom. Während diese Chromkarbidphasen sich schon bei geringer Substratstromerhöhung zeigten, musste im Falle des Titans mit höheren Substrationenströmen bzw. mit höherem Substratbias gearbeitet werden, um eine Karbidbildung nachzuweisen.

Es sei noch ein anderes experimentelles Resultat erwähnt, das die Diffusionsvorgänge betrifft, die durch den Energieeintrag der Ionen in die Substratoberfläche stimuliert werden. Es wurde mittels RBS und SIMS festgestellt, dass nach der Substratvorbehandlung eine deutliche Diffusion des Kobalts (Binder) zur Substratoberfläche hin stattfand. Eine Verbesserung der Schichthaftung und eine bessere Performance des Werkzeugs hat also auch darin ihre Ursache, dass eine durch einen Nassreinigungsschritt kobaltverarmte Hartmetalloberfläche wieder "ausgeheilt" wird und durch die Diffusion des Kobalts zur Oberfläche hin wieder genügend Festigkeit erhält.

Es wurde schon weiter oben erwähnt, dass ein Betrieb der Funkenquellen sogar im Reaktivgas allein möglich ist. Der Betrieb im Reaktivgas, vor allem bei höheren Drucken, kann aber dazu führen, dass der Substratstrom sinkt. Das wird auf Ladungsaustauschreaktionen zwischen den mehrfach geladenen Metall(Quellen)Ionen und den Reaktivgasatomen zurückgeführt. Hier hilft der gepulste Betrieb der Funkenquellen in zweifacher Hinsicht. Einmal erhöht er den Substratstrom, weil er mehrfach geladene Metallionen kreiert und zum anderen erhöht er auch die chemische Reaktionsfreudigkeit des Reaktivgases durch dessen höhere Ionisierung. Damit kommt es nicht nur zu chemischen Reaktionen mit den Metallgasionen und Komponenten der Substratoberfläche, sondern auch zu Reaktionen zwischen etwa Stickstoff mit den Komponenten der Substratoberfläche zur Bildung von Nitriden.

Auch die Substratvorbehandlung mit Sauerstoff als Reaktivgas zeigte u.a. bei nichtmetallischen Substraten, wie beispielsweise Oxidkeramiken, wesentliche Verbesserung in der Schichthaftung, vor allem beim Aufbringen oxidischer Schichten. Unterstützt werden kann dieser Prozess noch durch das Anlegen eines RF-Substrat-Bias.

Schliesslich soll noch angefügt werden, dass ein höherer Reaktivgasdruck, die Spritzer weiter reduziert aber das Pulsen der Quellen es ermöglich, den Substratstromverlust auszugleichen. Die üblichen nasschemische Vorbehandlungen können, besonders bei Hartmetallsubstraten wie Wendeschneidplatten oder auch bei bestimmten Typen des HSS, zu einer Verarmung der Substratoberfläche bezüglich bestimmter Materialkomponenten führen (beispielsweise zu einer Verarmung des Binders im Hartmetall für den häufig Kobalt verwendet wird). Besonders kritisch ist das bei Wendeschneidplatten, bei denen üblicherweise sogar die Konzentration des Kobalts zur Substratoberfläche hin erhöht wird, um der Schneidkante eine höhere Festigkeit zum besseren Tragen der später aufgebrachten Hartstoffschicht (TiC, TiCN, Al203) zu verleihen (Ref US_04497874). Der Erfinder konnte herausfinden, dass das beschriebene erfindungsgemässe Verfahren dazu beiträgt, dass eine Diffusion des Kobalts zur Substratoberfläche hin initiiert werden kann und damit die Schäden der nasschemischen Vorbehandlung weitgehend ausgeglichen werden können. Bis anhin musste die geschädigte Schicht durch einen längeren Ätzschritt in der Beschichtungskammer entfernt werden, damit die Schichthaftung gewährleistet werden konnte. Wie der Erfinder des Weiteren festgestellt hat, ist dieser Heilungsprozess besonders im Falle von Schneidkanten und insbesondere bei Wendeschneidplatten durch den erhöhten Ionenbeschuss an der Schneidkante der Substrate sehr wirkungsvoll. Eine mögliche Erklärung ist, dass die Erhöhung des Ionenbeschusses durch die Feldüberhöhung bei Anlegen eines Bias an Geometrien mit kleinem Kantenradius verursacht wird. Dies wurde hier am Beispiel der Kobaltdiffusion erläutert, trifft aber im Wesentlichen auch auf andere Arten von thermisch gesteuerten "Ausheilprozessen" an der Substratoberfläche zu.

Eine weitere vorteilhafte Anwendung bezieht sich auf karbidische Phasen des Wolframs. Diesbezüglich ist aus der CVD Technologie bekannt, dass solche karbidische Phasen des Wolframs (sog. eta Phase, Ref US_04830886) brüchig und verantwortlich sind für eine schlechte Haftung einer im Weiteren aufgebrachten Hartstoffschicht. Der Erfinder hat festgestellt dass mithilfe des erfindungsgemässen Verfahrens die Überführung instabiler Kohlenstoffverbindungen und ungebundenen Kohlenstoffs durch die im Verfahren verwendeten hochenergetischen Metallionen in stabile Karbide oder Mischkristalle gelingt.

Die durch den Ionenbeschuss vor allem auch der mehrfach geladenen Ionen bewirkten hohen Temperaturen auf der Substratoberfläche, besonders wieder aber an der Schneidkante des Werkzeuges fördern neben den oben besprochenen chemischen Reaktionen auch Diffusionsvorgänge sowohl des verwendeten Targetmaterials wie auch des Substratmaterials. Der Erfinder hat festgestellt, dass sich Diffusion beispielsweise von Ti in die äussersten Schichten der Substratoberfläche vorteilhaft für die Haftung einer Hartstoffschicht auswirkt, die ebenfalls Ti enthält, wie beispielsweise TiN, TiCN oder TiAlN. Besonders von Vorteil ist dieses Eindiffundieren von Targetatomen in das Substrat dann, wenn gut haftende Übergänge zu Hartstoffschichten mit sehr unterschiedlichen physikalischen und mechanischen Eigenschaften realisiert werden sollen, wie beispielsweise bei einer direkten Abscheidung von Aluminiumoxid oder Aluminiumchromoxid oder Bornitrid oder Siliziumnitrid auf dem Hartmetall. Damit steht ein sehr gutes und erfinderisches Verfahren zur Beschichtung von Hartmetall mit diesen Schichten zur Verfügung.

Weiter hat der Erfinder festgestellt, dass diese Methode des Eindiffundierens auch bei den Übergängen in Multilagenschichtsystemen verwendet werden kann. Dabei ist es von grossem Vorteil, dass die Energie der einfallenden Ionen vor allem auf den Bereich der Substratoberfläche beschränkt gehalten werden kann und dass ein üblicher Vorbehandlungsschritt üblicherweise nur wenige Minuten dauert, was zwar an der Substratoberfläche und gegebenenfalls wieder besonders auf der Schneidkante, aber nicht zu einer übermässigen thermischen Belastung des gesamten Substrates führt.

Da die oben besprochenen Diffusionsvorgänge durch die lokale Temperaturüberhöhung während des Ionenbeschusses bewirkt werden, ist nach der Behandlung der Bereich des Substrat-Schicht-Übergangs auch bei den späteren Schneidanwendungen und den damit verbundenen erhöhten Substrattemperaturen thermisch stabil und reduziert entsprechend die unerwünschten Diffusionsvorgänge während des Werkzeuggebrauchs.

Basierend auf dem oben besprochenen Tatsachen besteht ein weiterer Vorteil des Verfahrens, dass Targets der Materialien verwendet werden können, die dann auch zur Synthese der Hartstoffschicht benutzt werden, d.h. die Diffusionsvorgänge und die chemischen Reaktionen werden bereits mit Materialien durchgeführt, die später in der Schicht wiederkehren. Es können also auch Legierungstargets und verschiedene Reaktivgase bei dieser Methode eingesetzt werden, um chemische Reaktionen und Diffusionsvorgänge gezielt zu initiieren.

Der Vorbehandlungsschritt kann auch dazu verwendet werden, dass beispielsweise metallische Bestandteile in der Substratoberfläche unter Benutzung eines Reaktivgases in Verbindungen überführt werden, die hochtemperaturstabil sind und das Nukleationsverhalten der später abzuscheidenden Schicht gezielt beeinflussen. Als Beispiele soll hierbei die Formierung von Korundphasen auf Aluminium oder Chrom genannt werden.

## Patentansprüche

1. Verfahren zur Oberflächenbehandlung von Werkstücken in einer Vakuumbehandlungsanlage mit einer als Target ausgebildeten ersten Elektrode die Teil einer Arcverdampfungsquelle ist, wobei über der ersten Elektrode ein Funken mit Funkenstrom betrieben wird durch welchen Material vom Target verdampft wird welches sich zumindest teilweise und zeitweise auf den Werkstücken ablegt und mit einer zweiten Elektrode, die als Werkstückhalterung ausgebildet ist und zusammen mit den Werkstücken eine Biaselektrode bildet, wobei an die Biaselektrode mittels einer Spannungsversorgung eine Biasspannung angelegt wird, wobei die Biasspannung in Abstimmung mit dem Funkenstrom so angelegt wird, dass netto im Wesentlichen kein Materialaufbau auf der Oberfläche stattfindet, **dadurch gekennzeichnet, dass** die erste Elektrode mit gepulstem Strom betrieben wird, wobei durch das Pulsen zu ein gegenüber dem ungepulsten Betreiben erhöhter Substratstrom durch die Werkstücksoberfläche erzeugt wird und **dadurch** bei gegenüber ungepulsten Betreiben der ersten Elektrode niedrigerer Biasspannung netto kein Materialaufbau auf der Oberfläche stattfindet.

2. Verfahren nach Anspruch 1, **dadurch gekennzeichnet, dass** das Verfahren Arbeitsgas frei und/oder Reaktivgas frei durchgeführt wird.

3. Verfahren nach einem der vorangehenden Ansprüche, **dadurch gekennzeichnet dass** die Substratbiasspannung gepulst betrieben wird.

4. Verfahren nach Anspruch 3, **dadurch gekennzeichnet, dass** die aktuelle Pulsfrequenz der Substratbiasspannung ein ganzzahliges Vielfaches der Pulsfrequenz des Funkenstroms ist, einfach ist mit eingeschlossen.

5. Verfahren nach Anspruch 4, **dadurch gekennzeichnet, dass** das Pulsen der Biasspannung gegenüber dem Pulsen des Funkenstroms um ein Zeitintervall phasenverschoben ist, welches im wesentlichen der mittleren Flugdauer der Ionen vom Target zum Substrat entspricht.

6. Verfahren nach einem der vorhergehenden Ansprüche, **dadurch gekennzeichnet, dass** als Substrat ein Hartmetall verwendet wird, wobei die Substratoberfläche eine Schneidekante, wie eine Wendeschneidplatte ist, wobei das Verfahren zum Ausheilen einer Kobaltverarmung an der Oberfläche ausgeführt wird.

7. Verfahren nach einem der Ansprüche 1 bis 5, **dadurch gekennzeichnet, dass** das Targetmaterial und/oder gegebenenfalls das Reaktionsgas mit Materialkomponenten des Substrats chemisch reagieren und vorzugsweise **dadurch** stabilere Bestandteile bilden.

8. Verfahren nach Anspruch 7, **dadurch gekennzeichnet, dass** als Target ein metallisches Target verwendet wird, das Substrat Kohlenstoff enthält und die chemische Reaktion zur Bildung von Karbiden führt.

9. Verfahren nach einem der vorangegangenen Ansprüche, **dadurch gekennzeichnet, dass** der Puls des Funkenstroms derart gewählt ist, dass Stromanstiegswerte von mindestens 1000A/ms bevorzugt von mindestens 10000A/ms vorkommen.

10. Verwendung des Verfahrens nach einem der vorhergehenden Ansprüche, zum zumindest teilweisen Ausheilen von im Vergleich zum Substratinnern an der Oberfläche verarmter Materialkonzentration.

## Claims

1. Method for the surface treatment of workpieces in a vacuum treatment system having a first electrode configured as a target, which is part of an arc vaporization source, wherein, above the first electrode, an arc is operated with an arc current, by means of which material is vaporised from the target that is deposited at least partially and intermittently onto the workpieces, and having a second electrode that is configured as a workpiece holder and, together with the workpieces, constitutes a bias electrode, wherein, by means of a voltage supply, a bias voltage is applied to the bias electrode, the bias voltage being applied so that it is matched to the arc current such that substantially, no net material build-up on the surface occurs, **characterised in that** the first electrode is operated with a pulsed current, a substrate current through the workpiece surface which is increased in comparison to a non-pulsed operation is generated by the pulsation, and thus, no net material build-up on the surface occurs at a bias voltage that is lower compared with a non-pulsed operation of the first electrode.

2. Method according to claim 1, **characterised in that** the method is carried out without working gas and/or without reactive gas.

3. Method according to any one of the preceding claims, **characterised in that** the substrate bias voltage is operated in a pulsed manner.

4. Method according to claim 3, **characterised in that** the currently present pulse frequency of the substrate bias voltage is an integral multiple of the pulse frequency of the arc current, including a multiplication by one.

5. Method according to claim 4, **characterised in that** relative to the pulsing of the arc current, the pulsing of the bias voltage is phase-shifted by a time interval that substantially corresponds to the average flight time of the ions from the target to the substrate.

6. Method according to any one of the preceding claims, **characterised in that** a hard metal is used as a substrate, wherein the substrate surface is a cutting edge such as an indexable insert, the method being carried out to heal a cobalt depletion on the surface.

7. Method according to any one of claims 1 to 5, **characterised in that** the target material, and/or optionally the reaction gas, react(s) chemically with material components of the substrate, preferably producing more stable components thereby.

8. Method according to claim 7, **characterised in that** a metallic target is used as the target, the substrate contains carbon, and the chemical reaction results in the formation of carbides.

9. Method according to any one of the preceding claims, **characterised in that** the pulse of the arc current is selected so that current rise values of at least 1,000 A/ms and preferably at least 10,000 A/ms occur.

10. Use of the method according to any one of the preceding claims for the at least partial healing of material concentration on the surface, which is depleted as compared to the substrate interior.

## Revendications

1. Procédé pour le traitement de surface de pièces à oeuvrer dans une installation de traitement sous vide avec une première électrode, réalisée sous forme de cible, qui forme partie d'une source de la vaporisation par arc, dans lequel une étincelle est entretenue au moyen de la première électrode avec un courant d'étincelle grâce auquel le matériau de la cible est vaporisé et vient se déposer au moins partiellement et temporairement sur les pièces à oeuvrer, et avec une seconde électrode, réalisée sous forme de porte-pièce et formant conjointement avec les pièces à oeuvrer une électrode de polarisation, dans lequel une tension de polarisation est appliquée au niveau de l'électrode de polarisation au moyen d'une alimentation en tension, ladite tension de polarisation étant appliquée en accord avec le courant d'étincelle de telle façon qu'il ne se produit sensiblement aucun apport net de matière sur la surface,
**caractérisé en ce que** la première électrode est alimentée avec un courant pulsé, de sorte que l'on engendre par la pulsation un courant de substrat, augmenté par rapport à l'alimentation avec un courant non pulsé, à travers la surface de la pièce à oeuvrer, et qu'il ne se produit de ce fait aucun apport net de matière sur la surface sous une tension de polarisation plus faible par rapport à l'alimentation non pulsée de la première électrode.

2. Procédé selon la revendication 1, **caractérisé en ce que** le procédé est mis en oeuvre sans utiliser de gaz de travail et/ou de gaz réactif.

3. Procédé selon l'une des revendications précédentes, **caractérisé en ce que** la tension de polarisation du substrat est alimentée de manière pulsée.

4. Procédé selon la revendication 3, **caractérisé en ce que** la fréquence actuelle des impulsions de la tension de polarisation du substrat est un multiple entier de la fréquence des impulsions du courant d'étincelle, y compris un multiple égal à un.

5. Procédé selon la revendication 4, **caractérisé en ce que** les impulsions de la tension de polarisation sont décalées en phase par rapport aux impulsions du courant d'étincelle à raison d'un intervalle temporel qui correspond sensiblement à la durée de passage moyenne des ions depuis la cible vers le substrat.

6. Procédé selon l'une des revendications précédentes, **caractérisé en ce que** l'on utilise comme substrat un métal dur, la surface du substrat possédant une arête tranchante, comme celle d'une plaque à tranchant réversible, le procédé étant mis en oeuvre pour remédier à un appauvrissement en cobalt au niveau de la surface.

7. Procédé selon l'une des revendications 1 à 5, **caractérisé en ce que** le matériau de la cible et/ou le cas échéant le gaz de réaction réagissent de manière chimique avec des composantes du matériau du substrat et forment de préférence de ce fait des éléments constitutifs plus stables.

8. Procédé selon la revendication 7, **caractérisé en ce que** l'on utilise comme cible une cible métallique, le substrat contient du carbone, et la réaction chimique mène à la formation de carbures.

9. Procédé selon l'une des revendications précédentes, **caractérisé en ce que** les impulsions du courant d'étincelle sont choisies de telle façon qu'il se produit des valeurs d'augmentation de courant d'au moins 1000 A/ms, de préférence d'au moins 10 000 A/ms.

10. Utilisation du procédé selon l'une des revendications précédentes, pour remédier au moins partiellement à une concentration de matériau appauvrie au niveau de la surface par comparaison à l'intérieur du substrat.
